# EUROPEAN PATENT APPLICATION

(11) **EP 3 524 652 A1**
(43) Date of publication of application: **14.08.2019**
(21) Application number: 17858069.2
(22) Date of filing: 09.08.2017
(51) Int. Cl.: C09J 7/20, H01L 21/301, B23K 26/38, C09J 11/06, B23K 26/70, C09J 133/06

(54) **LASER DICING ASSISTANCE SHEET**

(30) Priority: 06.10.2016 JP 2016198300
(71) Applicant: Kimoto Co., Ltd., Saitama 338-0013 (JP)
(72) Inventor: NOZAWA, Kazuhiro, Saitama-shi Saitama 338-0013 (JP)
(74) Representative: Strehl Schübel-Hopf & Partner
(86) International application number: PCT/JP2017/028991
(87) International publication number: WO 2018/066229

(57) **Abstract**

Provided is a laser dicing assistance sheet with which chips can be prevented from coming loose during full-cut dicing by laser light irradiation can be prevented. The laser dicing assistance sheet comprises an adhesive layer formed from an adhesive composition. The adhesive layer is characterized by being adjusted such that the residual weight (as measured under a flow of nitrogen (50 ml/min) at a heating rate of 10°C/min) of the constituent material (adhesive composition) at 500°C is not more than 5.5%.

## Description

### TECHNICAL FIELD

The present invention relates to a laser dicing assistance sheet used in the case where a laser light is used as a tool for processing (dicing) a workpiece (to be processed), such as a semiconductor water.

### BACKGOUND ART

Methods for cutting a semiconductor wafer using a laser light, by which damages due to heat is suppressed and highly precise processing is possible, are known. This technique is a method of fixing a workpiece, wherein, for example, various circuits are formed on a substrate and surface processing is performed thereon, to a dicing assistance sheet, dicing the workpiece with a laser light relatively passing the workpiece at a predetermined speed, and chipping it into small pieces (Patent Document 1).

### RELATED ART DOCUMENTS

### PATENT DOCUMENT

Patent Document 1: Japanese Patent Unexamined Publication (Kokai) No. 2004-79746

### SUMMARY OF THE DISCLOSED SUBJECT MATTER

However, when performing full-cut dicing on a workpiece by using conventional dicing assistance sheets as the technique in the patent document 1, etc., there arises a phenomenon (chip scattering) that chips made into pieces come off from the dicing assistance sheet by themselves after dicing, which results in posing a problem in the subsequent step (pickup step, etc.) and causes a yield decline in some cases.

According to one aspect of the present invention, a laser dicing assistance sheet capable of preventing chip scattering at full-cut dicing using laser light irradiation.

Present inventors made a hypothesis that an effect by heat (500 to 600 ° C or so) generated at a laser light irradiated part on a workpiece relates to chip scattering when processing (dicing) the workpiece, such as a semiconductor wafer, by laser light irradiation and concentrated on studying. As a result, they found that, by adjusting an adhesive layer adhered to the workpiece in order to bring out a predetermined physical property, it is possible to suppress spread of the effect of heat generated when irradiating a laser light and a decline of the adhesive fore on a part, on which chips should be held rightfully, can be reduced and a laser dicing assistance sheet having performance of preventing chip scattering can be obtained, and completed the present invention.

A laser dicing assistance sheet of the present invention is characterized by having an adhesive layer, wherein residual weight of the constituent material (an adhesive composition) at 500 ° C is adjusted to 5.5% or lower.

In the present invention, the adhesive layer may be adjusted so that residual weight of the constituent material at 250 ° C is 5.5% or more. Also, the adhesive layer may be adjusted so that a weight reduction start temperature is 150 ° C or higher and lower than 500 ° C. Also, the adhesive layer may be adjusted so that a 50% weight reduction temperature is 300 ° C or higher and lower than 500 ° C.

A laser dicing assistance sheet of the present invention has an adhesive layer, wherein residual weight of the constituent material at 500 ° C is adjusted to 5.5% or less, so that substantially all of the constituent material in the adhesive layer corresponding to a part irradiated with a laser light is decomposed or sublimated (disappears). Therefore, the phenomenon (a phenomenon caused as a result that an effect of heat, etc. generated by irradiating laser light spreads starting from the residual constituent material to around the laser light irradiated part (not-irradiated part) and the adhesive fore declines on the spread part) to be generated in the case where a part of the constituent material of the adhesive layer corresponding to a part irradiated with laser light remains is not caused. As a result, respective chips made into pieces after full-cut dicing are not released from corresponding adhesive layer and held.

Namely, according to the laser dicing assistance sheet of the present invention, it is possible to prevent respective chips made into pieces from scattering at full-cut dicing using laser light irradiation. Thereby, no obstacle is posed in subsequent steps (pickup step, etc.). and a decline of yield is suppressed.

### EXEMPLARY MODE FOR CARRYING OUT THE DISLCOSED SUBJECT

### MATTER

Embodiments of the present invention will be explained. Below, one surface (a surface on the side an adhesive layer is stacked) of a substrate film will be also abridged and referred to simply as "a surface" and the other surface (an opposite surface of the adhesive layer-stacked side) of the substrate film will be also abridged and referred to as "a reverse surface" or "a back surface".

A laser dicing assistance sheet according to an embodiment of the present invention comprises a substrate film and an adhesive layer stacked on one surface of the substrate film. Below, processing work of a semiconductor wafer will be taken as an example to explain embodiments of respective components.

### < Adhesive Layer >

An adhesive layer to be stacked on a surface of a substrate film is characterized in that residual weight of the constituent material (an adhesive agent composition) is adjusted to 5.5% or less (preferably 5% or less and more preferably 3 % or less) at 500°C.

The present inventors found that, when using an adhesive layer exhibiting such a physical property, substantially all of the constituent material of the adhesive layer can be decomposed or sublimated (that is, made to be disappeared) on a part irradiated with a laser light (a region corresponding to streets between circuits in the example below). Since substantially all of the constituent material of the adhesive layer corresponding to a part irradiated with a laser light can be made disappeared, the constituent material of the adhesive layer remains on other region of the irradiated region (a region contacting chips after cutting) is not affected by laser light irradiation and an adhesive force on the region does not change before and after the laser light irradiation. As a result, scattering of the chips can be prevented effectively.

When using an adhesive layer wherein a residual weight of the constituent material at 500°C becomes more than 5.5%, substantially all of the constituent material of the adhesive layer corresponding to the laser light irradiated part cannot be made disappeared, consequently, starting from the residual constituent material, the effect of heat generated by the laser light irradiation spreads to around the laser light irradiated part and the adhesive force declines on the spread part, which results in scattering of chips in some cases.

Preferably, in an adhesive layer according to an embodiment of the present invention, residual weight of the constituent material at 250 °C is adjusted, for example, to 5.5% or more (preferably 50% and more preferably 90% or more). In addition to the characteristic above (residual weight of the constituent material at 500 °C is 5.5% or less), it is apt to obtain advantages, such as preventing an unexpected decline of the adhesive fore in other heating process, etc. than laser light irradiation.

A composition of the adhesive layer is not particularly limited as long as the characteristic above (residual weight of the constituent material at 500 °C is 5.5% or less) can be obtained, and the adhesive layer may be formed, for example, by an adhesive agent composition shown below.

As an adhesive agent composition according to an embodiment of the present invention, those having a weight reduction start temperature of 150 °C or higher but lower than 500 °C and/or those having a 50% weight reduction temperature of 300 °C or higher but lower than 500 °C, etc. may be mentioned. When a weight reduction start temperature and/or 50% weight reduction temperature of the composition to be used is too high, residual weight at 500 °C of the composition to be used is hard to be 5.5% or less, while when too low, an adhesive layer other than the cut parts is susceptible to the effect of heat.

As the weight reduction start temperature of the composition to be used is preferably 170 °C or higher and more preferably 200 °C but preferably 450 °C or lower and more preferably 400 °C or lower. Also, as the 50% weight reduction temperature of a composition to be used is preferably 325 °C or higher, more preferably 350 °C or higher, but preferably 480 °C or lower and more preferably 450 °C or lower. When the weight reduction start temperature and/or 50% weight reduction temperature of a composition to be used are in those ranges, residual weight at 500 °C of a composition to be used becomes 5.5% or less easily.

Note that, in the present invention, residual weight (%) at 500 °C or 250 °C, weight reduction start temperature(°C), and 50% weight reduction temperature (°C) are measured by using a general TG-DTA (Thermogravimeter - Differential Thermal Analyzer) measurement device, for example, TG/DTA 6200 (made by SII Nano Technology Inc.) and by heating from 30 °C to 600 °C under condition of a temperature rising rate of 10 °C/min. in a nitrogen stream (50ml/min.). As a measurement sample, a constituent material of an adhesive layer (an adhesive agent composition) is used and the measurement is made preferably by pressing at a normal temperature, folding by using tweezers to be in a shape not including any bubbles to a maximum extent in order to improve measurement precision.

As an adhesive agent composition according to an embodiment of the present invention, for example, it is particularly preferable to use those exhibiting a performance that the adhesive force declines by being irradiated with an active energy ray and able to be removed easily. By configuring an adhesive layer with an active energy ray curable type adhesive agent composition, particularly releasability of workpieces can be improved.

Those sometimes include, for example, an active energy ray polymerization compound, cross-linking agent and polymerization initiator, etc. in addition to an acrylic polymer as the main adhesive agent.

An acrylic polymer is a component constituting a base polymer of the adhesive agent composition according to an example. Generally, as a base polymer for an adhesive agent composition, various polymers, such as acrylic, epoxy-type, polyester-type and silicon-type polymers, are widely known. Among them, acrylic polymers are superior in terms of transparency, heat resistance, cost and easiness in controlling the adhesive force, etc. Therefore, in an embodiment of the present invention, an acrylic polymer may be applied as a base polymer.

As an acrylic polymer, a copolymer including as an essential component a recurring unit (U1) derived from acrylate ester and possibly including other recurring unit (U2) as constituent units thereof may be used.

As acrylate esters capable of generating a recurring unit (U1), for example, ethyl acrylate, methyl acrylate, methyl methacrylate, n-butyl acrylate, 2-ethyl hexyl acrylate, 2-ethyl hexyl methacrylate, isooctyl acrylate, isononyl acrylate, glycidyl acrylate, glycidyl methacrylate, dimethyl aminoethyl methacrylate, tert-butyl aminoethyl methacrylate and other (meth)acrylate-type monomers may be mentioned. Among them, n-butyl acrylate, 2-ethyl hexyl acrylate and methyl methacrylate are preferable (meth)acrylate-type monomers in terms of transparency, heat resistance and an adhesive force, etc.

Note that "(meth)acrylate" means acrylate or methacrylate.

As acrylate esters, as a hydroxyl group-containing acrylate ester having a hydroxyl group, for example, 2-hydroxyl ethyl acrylate, 2-hydroxyethyl methacrylate, 2-hydroxy propyl acrylate, 2-hydroxybutyl acrylate, 3-chloro-2-hydroxypropyl acrylate, polyethylene glycol acrylate, propylene glycol acrylate and other (meth)acrylate-type monomers may be mentioned. Among them, particularly 2-hydroxyethyl acrylate is a preferable hydroxyl group-containing (meth)acrylate-type monomer.

As a monomer capable of generating other recurring unit (U2) other than acrylate esters, for example, acrylamide, methacrylamide, acrylonitrile, styrene, vinyl acetate, acrylic acid, methacrylic acid, itaconic acid, etc. may be mentioned. Among them, acrylonitrile, etc. are preferable. Acrylonitrile is capable of improving a cohesive force.

The above-mentioned monomers capable of generating recurring units (U1 and U2) may be used alone respectively or in combination of two or more kinds.

It is preferable that an acrylic-type polymer does not have a carboxyl group. It is because, when using one having a carboxyl group, releasability of workpieces declines after irradiating an active energy ray in some cases. To obtain an acrylic-type polymer not having any carboxyl group, carboxyl group-containing monomer is not used as a monomer generating a recurring unit of the acrylic-type monomer. The carboxyl group-containing monomer is, for example, vinyl acetate, acrylic acid, methacrylic acid and itaconic acid, etc. among the above-mentioned monomers.

An acrylic-type polymer preferably has a hydroxyl group, because it is beneficial to maintain the adhesiveness when using one having a hydroxyl group. To obtain an acrylic-type polymer having a hydroxyl group, a hydroxyl group-containing monomer may be used as a monomer generating a recurring unit of acrylic-type polymer. Among the above-mentioned monomers, a hydroxyl group-containing monomer is, for example, 2-hydroxyethyl acrylate, 2-hydroxyethyl methacrylate, 2-hydroxypropyl acrylate and other hydroxyl group-containing acrylate esters as hydroxyl group-containing (meth)acrylate monomer.

Weight-average molecular weight (Mw) of an acrylic-type polymer is, for example, 10,000 to 1,000,000 and more preferably 200,000 to 800,000. When weight-average molecular weight is out of the range above, disadvantages may arise, such that the adhesive force declines and thermal decomposition becomes hard. The weight-average molecular weight is a polystyrene conversion value by gel permeation chromatography (GPC) measurement.

As an active energy ray polymerizable compound, compound A or compound B which is polymerizable by being irradiated with an active energy ray may be mentioned.

Compound A is not particularly limited as long as it is polymerizable by being irradiated with an active energy ray, and a radical-polymerizable, cation-polymerizable and anion-polymerizable compounds may be used. For example, to take a radical-polymerizable compound as an example, polyurethane (meth)acrylate, polyester (meth)acrylate, epoxy (meth)acrylate, polyol (meth)acrylate, polyether (meth)acrylate, melamine (meth)acrylate, silicon-type (meth)acrylate and other multifunctional (meth)acrylate, etc. (for example, tetramethylolmethane tetra(meth)acrylate, dipentaerythritol hexa(meth)acrylate, dipentaerythritol penta(meth)acrylate etc.) may be mentioned. Among them, polyurethane (meth)acrylate is preferable in terms of compatibility and adhesive force, etc. Compound A may be used alone or in combination of two or more kinds.

Weight-average molecular weight (Mw) of compound A may be, for example, 300 or more, preferably 350 or more but, for example, less than 10,000 and preferably 900 or less. When the weight-average molecular weight is out of the range, disadvantages may arise, such as a decline of an adhesive force and arise of adhesive residue. The weight-average molecular weight is a polystyrene conversion value by GPC measurement as same as in the case of an acrylic-type polymer.

As a market-available product of compound A, for example, NK Oligo (made by Shin-Nakamura Chemical Co., Ltd), SHIKOH (registered trademark: made by The Nippon Synthetic Chemical Industry Co., Ltd. (NIPPON GOHSEI)) and Aronix (made by TOAGOSEI Co., Ltd.) may be mentioned.

A content of the compound A is normally 10 to 200 parts by weight and preferably 20 to 120 parts by weight with respect to 100 parts by weight of acrylic-type polymer. When the content is out of the range, disadvantages may arise, such that the adhesive force becomes hard to decline and adhesive residue arises easily.

An adhesive agent composition as an example may also include compound B having Mw of less than 300 and polymerizable by active energy ray irradiation besides the compound A above. Compound B is may be various compounds, such as radical-polymerizable, cation-polymerizable and anion-polymerizable compounds. When showing a radical-polymerizable compound as a specific example belonging to the compound B, a multifunctional (meth)acrylate-type monomer having three or more (meth)acryloyl groups in one molecular may be mentioned. As a multifunctional (meth)acrylate-type monomer, for example, trimethylolmethane tri(meth)acrylate, trimethylolethane tri(meth)acrylate, trimethylolpropane tri(meth)acrylate, pentaerythritol tri(meth)acrylate, and ethylene oxide or propylene oxide adduct of these, etc. are preferable.

Such multifunctional (meth)acrylate-type monomers may also provide advantages, such that the adhesive force is decreased by irradiating an active energy ray and adhesive residue can be reduced.

When the compound B above is contained in the adhesive agent composition as an example, a total content of the compound B and the compound A is preferably 10 to 200 parts by weight and more preferably 20 to 120 parts by weight with respect to 100 parts by weight of acrylic-type polymer. By adjusting the total content, the adhesive force may be controlled easily after irradiating an active energy ray. When in the above range, a crosslinking density after active energy ray irradiation becomes sufficient, so that proper releasability of workpieces can be attained.

A crosslinking agent is not particularly limited as long as it is a compound capable of generating a crosslinked structure. For example, compounds, which react with a functional group in an acrylic-type polymer and is capable of crosslinking an acrylic-type polymer, may be mentioned. This compound is preferable particularly in terms of providing the effect of improving a cohesive force due to crosslinking and improving arising of adhesive residue.

When an acrylic-type polymer has a hydroxyl group as its functional group, an isocyanate-type crosslinking agent is preferable as the crosslinking agent capable of reacting with the hydroxyl group and generating a crosslinked structure. It is because the crosslinking agent makes it possible to improve a cohesive force of the adhesive layer and to improve adhesive residue.

As an isocyanate-type crosslinking agent, for example, polyisocyanate, a trimer of polyisocyanate, an urethane polymer having an isocyanate group at its terminal obtained by reacting polyisocianate with polyol, and a trimer of the urethane prepolymer, which are polyisocyanate-type compounds having two or more isocyanate groups in one molecule, etc. may be mentioned.

As a polyisocyanate, for example, 2,4-tolylene diisocyanate, 2,5-tolylene diisocyanate, 1,3-xylylene isocyanate, 1,4-xylylene diisocyanate, diphenylmethane-4,4'-diisocyanate, 3-methyldiphenylmethane diisocyanate, hexamethylene diisocyanate, isophorone diisocyanate, dicyclohexyl methane-4,4'-diisocyanate, dicyclohexyl methane-2,4'-diisocyanate, lysine isocyanate, etc. may be mentioned.

The crosslinking agents may be used alone or in combination of two or more kinds.

As a market-available product of isocyanate-type crosslinking agents, for example, CORONATE (registered trademark) L (made by Nippon Polyurethane Industry Co., Ltd.), L-45 (made by Soken Chemical & Engineering Co., Ltd.), TD-75 (made by Soken Chemical & Engineering Co., Ltd.), BXX5627 (made by TOYO INK Co., Ltd) and X-301-422SK (made by Saiden Chemical Industry Co., Ltd.), etc. may be mentioned.

A content of the crosslinking agent is, in the case of an isocyanate-type crosslinking agent, normally 0.01 to 8 parts by weight and preferably 0.1 to 4 parts by weight with respect to 100 parts by weight of a total of an acrylic-type polymer and an active energy ray polymerizable compound. It is because disadvantages are caused, such that when the content is less than the range above, it is hard to obtain a sufficient adhesive force, while when the content exceeds the range above, adhesive residue arises easily due to residual unreacted isocyanate.

A polymerization initiator is not particularly limited and well-known ones may be used. For example, 2-hydroxy-2-methyl-1-phenylpropane-1-one, 1-hydroxy cyclohexylphenyl ketone and other acetophenones, benzoin, benzoin isobutylether and other benzoins, benzophenone, hydroxybenzophenone and other benzophenones, thioxanthone, 2,4-diethyl thioxanthone and other thioxanthones, etc.

As market-available products of the polymerization initiator, for example, Irgacure (registered trademark) 184 '1-hydroxy-cyclohexyl-phenyl-ketone), Irgacure (registered trademark) 754 (Blend of oxy-phenyl-acetic acid 2-[2-oxo-2-phenyl-acetoxy-ethoxy]-ethyl ester and oxy-phenyl-acetic acid 2-[2-hydroxy-ethoxy]-ethyl ester), Irgacure (registered trademark) 2959 (1-[4-(hydroxyethoxy)-phenyl]-2-hydroxy-2 methyl-1-propane-1-one) made by BASF Japan Ltd. and KAYACURE DETX-S (2,4-diethylthioxanthone) made by Nippon Kayaku Co., Ltd., etc. may be used.

A content of the polymerization initiator is normally 0.05 to 6 parts by weight and preferably 0.2 to 4 parts by weight with respect to 100 parts by weight of a total of an acrylic-type polymer and an active energy ray polymerizable compound. It is because disadvantages arise in some cases, such that it becomes hard to reduce the adhesive force by irradiation of an active energy ray, when the content is less than the range above.

As an active energy ray, for example, an ultraviolet ray, visible rays, electron ray, X-ray and γ-ray, etc. may be mentioned, and among them, an ultraviolet ray is typical in terms of costs of an irradiation device, etc.

An adhesive agent composition as an example may include various additives, such as a silane coupling agent, metal chelating agent, surfactant, antioxidant, ultraviolet absorber, colorant, antistatic agent, anticorrosion agent, defoaming agent and wettability modifier besides a solvent, as needed within the scope of the present invention.

An adhesive agent composition according to an example may be produced, for example, by dissolving or dispersing an acrylic-type polymer, active energy ray polymerizable compound, crosslinking agent, polymerization initiator and, furthermore, a variety of additives to be added when required in an organic solvent. As an organic solvent, it is not particularly limited and, for example, toluene, methylethyl ketone, ethyl acetate, dimethyl acetoamide and a mixed solvent of two or more kinds of those, etc. may be used.

A thickness of the adhesive layer is determined accordingly in consideration of bringing a sufficient adhesive force before and after irradiation of a laser light and not letting undesirable adhesive agent residue remain (not letting any adhesive residue remain) after removing a laser dicing assistance sheet of the present invention from a semiconductor wafer, etc. and is, for example, 5 to 50µm and preferably 10 to 40µm. It is more preferably 15 to 35µm particularly in terms of handleability.

An adhesive layer may be formed by applying the prepared adhesive agent composition to a surface of a substrate film and drying. As the application method of the adhesive agent composition, a variety of methods may be applied, such as bar coater, air-knife coater, a gravure coater, gravure reverse coater, reverse roll coater, lip coater, die coater, dip coater, offset printing, flexographic printing and screen printing. Also, a method of separately forming an adhesive layer on a releasable liner and then sticking the same to the substrate film, etc. may be applied, as well.

After depositing an adhesive layer on a surface of a substrate film until it is used, a mold release film as a separator may be put on a surface (an opposite surface of the substrate film) of the adhesive layer.

### < Substrate Film >

A substrate film may be selected from well-known self-supporting films. The substrate film is preferably in a sheet shape having a uniform thickness but may be in a mesh shape, etc. as well. Also, the substrate film may be a single layer or of a multilayer structure with two or more layers.

As a material of the substrate film, for example, polymer films formed by an acrylic-type resin, polyurethane-type resin, polynorbornene-type resin, polyalkylene glycol-type resin, polyolefin-type resin (polystyrene-type resin, polyethylene-type resin, etc.), polyimide-type resin, polyester-type resin, epoxy-type resin, polyamide-type resin, polycarbonate-type resin, silicon-type resin, fluorine-type resin and ionomer-type resin, etc.; metal sheets of copper, aluminum and stainless steel; unwoven fabrics made of polymer fibers, such as PP, PVC, PE, PU, PS, PO and PET, synthetic fibers, such as rayon and cellulose acetate, natural fibers, such as cotton, silk and wool, and inorganic fibers, such as glass fiber and carbon fiber; sheets added with a physical or optical function by performing drawing processing or impregnation processing, etc.; sheets including diene-type (styrene-butadiene copolymer, butadiene, etc.), non-diene-type (isobutylene-isoprene, polyethylene chloride, urethane-type, etc.), thermoplastic-type (thermoplastic elastomer, etc.) and other rubber components; or those obtained by combining one or more of those may be mentioned.

Among them, polyolefin-type resins, specifically, polyethylene (for example, low density polyethylene, straight chain low density polyethylene, high density polyethylene, etc.), polypropylene (for example, stretched polypropylene, non-stretched polypropylene, etc.), ethylene copolymers, propylene copolymers, ethylene-propylene copolymer, etc. are preferable. When the substrate film has a multilayer structure, it is preferable that at least one layer is formed by a polyolefin-type resin.

Particularly, as the substrate film materials, as will be explained below, it is preferable to select from those hard to be cut by a laser light for cutting workpieces in consideration of at least one characteristic of, two or more characteristics of, preferably all the characteristics of light transmissivity, stacked state, elongation at break, light absorption coefficient, melting point, thickness, strength at break, specific heat, etching rate, Tg, thermal deformation temperature and specific gravity, etc.

The substrate film preferably has a thickness of 50µm or more, more preferably 100µm or more and 150µm or more, and 50 to 500µm or so is furthermore preferable. Thereby, operability and workability can be secured in respective steps of, for example, sticking to a semiconductor water, cutting of the semiconductor wafer, removing from semiconductor chips, etc.

The substrate film preferably has transmissivity of a laser light, specially a laser light having a wavelength of around 355nm to around 600nm, of 50% or more, preferably 55% or more, more preferably 60% or more and furthermore preferably 65% or more. The light transmissivity may be measured, for example, by using an ultraviolet visible light spectrophotometer. Thereby, deterioration of the substrate film itself due to a laser light can be prevented.

The substrate film preferably has a multilayer structure of two or more layers of different materials. Here, a different material means not only having a different composition but includes those having the same composition but different characteristics because of a different molecular structure or molecular weight, etc. For example, it is suitable to stack those having at least one different characteristic among the above-mentioned light absorption coefficient, melting point, strength at break, elongation at break, light transmissivity, specific heat, etching rate, Tg, thermal deformation temperature, linear expansion coefficient, and specific gravity, etc.

Among them, at least one layer in the multilayer structure of two or more layers is preferably made by a resin not including any benzene ring, or a chain saturated hydrocarbon-type resin, for example, a polyolefin-type resin.

As polyolefin-type resins, one or more kinds selected from polyethylene, polypropylene, ethylene copolymer, propylene copolymer, ethylene-propylene copolymer, polybutadiene, polyvinyl alcohol, polymethyl pentene, ethylene-vinyl acetate copolymer, polyvinyl acetate, etc. may be preferably used. Among them, it is preferably at least one kind selected from ethylene and propylene-type (co)polymer, furthermore, polyethylene, polypropylene, ethylene copolymer, propylene copolymer, ethylene-propylene copolymer. By selecting from these materials, it is possible to hit a balance between suitable extensibility and suitable strength against laser processing.

When the substrate film has a multilayer structure, it is preferable to include both of a polyethylene resin layer and a polypropylene resin layer. Particularly, a two-layer or three-layer structure including these layers is preferable. In that case, it is more preferable that a polypropylene resin layer is positioned far from an adhesive layer. For example, in the case of a two-layer structure, it is preferable that a polypropylene resin layer is placed on the back surface side of the substrate film and a polyethylene resin layer is placed on the adhesive layer side and, in the case of a three-layer structure, it is preferable that a polypropylene resin layer is placed on the back surface side of the substrate film or on one layer closer position to the adhesive layer side and a polyethylene resin layer is placed on the adhesive layer side. It is because such arrangements enable to secure suitable extensibility of the substrate film because of the layer formed by the polypropylene resin, which is a relatively soft resin, on the most back surface side even if a part of the substrate film is damaged during laser processing.

The substrate film preferably includes at least two layers having different elongation at break. Elongation at break may be measured, for example, by using a versatile tensile tester at a tensile speed of 200mm/min. based on JIS K-7127. Difference of elongation at break is not particularly limited but is, for example, about 100% or more and preferably about 300% or more. In that case, a layer with a larger elongation at break is preferably placed away from the adhesive layer. Namely, it is preferable that a layer having good extensibility is arranged on the reverse surface (back surface) of the substrate film, that is, the side hard to be cut by a laser light.

Particularly, the substrate film has elongation at break of preferably 100% or more. When the substrate film has a multilayer structure, it is not necessary that all layers have elongation at break of 100% or more, but the layer having good extensibility is preferably arranged on the most back surface side of the substrate film. Particularly, a substrate film having elongation at break of 100% or more and strength at break in the range explained above is preferable because chips formed by cutting a workpiece are easily separated from one another after performing laser dicing and stretching the dicing sheet.

The substrate film preferably includes at least two or more layers having different strength at break. Here, the strength at break may be measured by using a versatile tensile tester with a tensile speed of 200mm/min. based on JIS K-7127. Difference of strength at break is not particularly limited but is preferably, for example, about 20MPa or more and preferably about 50MPa or more. In that case, it is preferable that a layer having a higher strength at break is placed away from the adhesive layer. Namely, it is preferable that a layer having strength hard to be cut by a laser light is arranged on the back surface of the substrate film.

The substrate film preferably includes a layer having a melting point of 90°C or higher. Thereby, melting of the substrate film due to laser light irradiation can be prevented effectively. The melting point is preferably 95°C or higher, more preferably 100°C or higher and furthermore preferably 110°C or higher. When the substrate film has a single-layer structure, the composing layer itself has to have a melting point of 90°C or higher, while in the case of a multilayer structure, not all of the layers have to have a melting point of 90°C or higher but preferably at least one layer has a melting point of 90°C or higher. In that case, it is preferable that the layer is arranged on the side to be a back surface (for example, a side to contact with a chuck table) at laser processing.

The substrate film preferably has larger specific heat. The specific heat is, for example, about 0.5J/g·K or more, preferably about 0.7J/g·K or more, more preferably about 0.8J/g·K or more, furthermore preferably about 1.0J/g·K or more, still further preferably about 1.1J/g·K or more and most preferably about 1.2J/g·K or more. When the specific heat is relatively large, the substrate film itself becomes hard to be heated by heat generated by a laser light and a part of the heat is easily released to outside the substrate film. As a result, the substrate film is hard to be processed, cutting of the substrate film is suppressed to minimum and partial adhesion of back surface to a processing table can be prevented. The specific heat may be measured based on JIS K7123. Specifically, it is obtained by actually measuring a quantity of heat necessary for raising a temperature of a test piece at 10°C/mm² by using a differential scanning calorimeter (DSC).

The substrate film preferably has a low etching rate. For example, the etching rate is preferably 0.3 to 1.5µm/pulse with laser light intensity of 1 to 5J/cm² or so, more preferably 0.3 to 1.2µ/pulse, more preferably 0.3 to 1.1µ/pulse or so. Particularly, it is preferably 0.9µ/pulse or less, preferably 0.8µ/pulse or less and more preferably 0.7µ/pulse or less with laser light intensity of 1 to 2J/cm² or so. When the etching rate is low, cutting of the substrate film itself can be prevented.

Preferably, the substrate film preferably has a glass transition point (Tg) of about 50°C or lower, preferably about 30°C or lower and more preferably about 20°C or lower or 0°C or lower, or a thermal deformation temperature of about 200°C or lower, preferably about 190°C or lower, more preferably about 180°C or lower and furthermore preferably about 170°C or lower, alternatively, a specific gravity of about 1.4g/cm³ or lower, preferably about 1.3g/cm³ or lower, more preferably about 1.2g/cm³ or lower and furthermore preferably about 1.0g/cm³ or lower. When those characteristics are provided, cutting of the substrate film can be suppressed to minimum and it becomes advantageous for preventing partial adhesion of the back surface to a processing table.

The Tg and thermal deformation temperature may be measured, for example, by using a measurement method of a general plastic transition temperature based on JIS K7121 (specifically, a differential thermal analysis (DTA) and differential scanning calorimetry analysis (DSC), etc.). The specific gravity may be measured, for example, by using a generally-known plastic density (specific gravity) measurement method in JIS K7112 (specifically, water displacement method, pycnometry method, sink float method and density gradient method, etc.).

A surface of the substrate film may be subjected to a well-known surface treatment, for example, a chemical or physical treatment, such as a chronic acid treatment, exposure to ozone, exposure to flames, exposure to high-pressure electric shock and ionizing radiation treatment, or a coating treatment with an undercoat agent (for example, a later-explained adhesive substance), etc. in order to improve the adhesive fore and retention, etc. with adjacent materials, such as a table, etc. in a processing apparatus.

As an example of the present invention, a functional layer for bringing a variety of functions may be stacked on the other surface of the substrate film. The functional layer is not particularly limited and preferably, for example, the functional layer disclosed in the Japanese patent unexamined publication No. 2016-119432, that is, a layer which does not melt or is hard to melt by irradiation of a laser light and may be configured by a layer for protecting a back surface side of the substrate film, so that the substrate film does not stick to a processing table, etc. due to melting of the substrate film at a part with intensive laser light energy.

### < Method of Using Laser Dicing Assistance Sheet >

The laser dicing assistance sheet according to an embodiment of the present invention may be used preferably for a variety of processing using a laser light, for example, a production procedure of a semiconductor chip, etc. as follows. Below, an explanation will be made by taking an example of a production procedure of a semiconductor chip.

It may be used for the procedure of producing semiconductor chips, etc. by sticking the laser dicing assistance sheet according to an embodiment of the present invention in a way of facing the adhesive layer to the opposite surface of a circuit-formed surface of a semiconductor wafer, irradiating a laser light from the circuit-formed surface of the semiconductor wafer, and making the semiconductor wafer into individual pieces, one circuit on each piece.

Formation of circuits on the wafer surface is performed by a well-known method, such as an etching method and lift-off method. The circuits are formed in a grid on an inner circumferential portion of the surface of the wafer leaving an extra space with no circuit on a region of several millimeters from the outer circumferential edge. A thickness of the wafer before grinding is not particularly limited and is normally 500 to 1000µm or so.

When performing grinding processing on a back surface of the semiconductor wafer, a surface protective sheet may be adhered to the circuit surface side to protect circuits on the surface. The back surface grinding processing is performed by fixing the circuit side of the wafer by using a chuck table, etc. and grinding with a grinder the back surface with no circuits formed. After the back surface grinding process, processing of removing a fractured layer generated by the grinding may be performed.

Subsequently to the back surface grinding process, etching processing or other processing involving heating, and a treatment with a high temperature, such as deposition of a metal film or baking of an organic film, may be performed on the back surface in accordance with need. When performing a high temperature treatment on the back surface, it is performed after removing the surface protective sheet.

After the back surface grinding process, the adhesive layer of the laser dicing assistance sheet according to an embodiment of the present invention is placed facing to the opposite surface of the circuit-formed surface of the wafer and applied. Application of the laser dicing assistance sheet to the wafer is generally done by a device called mounter, but it is not limited to that.

Next, after the wafer applied with the laser dicing assistance sheet is placed on a processing table (chuck table) of a dicing apparatus with the back surface (a surface without the adhesive layer stacked) of the laser dicing assistance sheet facing downward, a laser light is irradiated from the wafer side to dice the wafer.

In the present invention, in the case of a semiconductor with high hardness, a short wavelength laser light having a high energy density is sometimes used to fully cut the semiconductor. As a short wavelength laser as such, for example, a laser having an oscillation wavelength of 400nm or less, specifically, a KrF eximer laser having an oscillation wavelength of 248nm, XeCI eximer laser with 308nm, the third harmonic (355nm) and fourth harmonic (266nm) of an Nd-YAG laser, etc. may be mentioned. Also, a laser having an oscillation wavelength of 400nm or more (for example, a titanium sapphire laser, etc. having a wavelength around 750 to 800nm with a pulse width of 1 nano second (1×10⁻⁹ second) or less may be used, as well.

Intensity and illuminance of the laser light depend on a thickness of the wafer to be cut and may be at a level capable of cutting the wafer fully.

The laser light is irradiated to streets between circuits to divide the wafer into chips, one circuit on each chip. The number of times that the laser light scans on one street may be one time or more. Preferably, irradiation of the laser light is performed while monitoring an irradiation position of the laser light and positions of the streets between circuits and aligning the laser light. A scan speed (feeding speed in processing) of the laser light is 80mm/sec. or higher, preferably 100mm/sec. or higher and more preferably 130mm/sec. or higher in consideration of the productivity.

After the dicing finishes, semiconductor chips are picked up from the laser dicing assistance sheet. The pickup method is not particularly limited and a variety of well-known methods may be applied. For example, the method of poking each semiconductor chip from below with a needle from the laser dicing assistance sheet side and picking up the poked semiconductor chips by using a pickup device, etc. may be mentioned. When the adhesive layer of the laser dicing assistance sheet is formed of an active energy ray curable adhesive agent composition, an active energy ray (ultraviolet ray, etc.) is irradiated to the adhesive layer to reduce the adhesive force before picking up the chips.

Picked up semiconductor chips are subjected to die bonding and resin sealing by a normal method, so that semiconductor devices are produced.

In the laser dicing assistance sheet according to an embodiment of the present invention, an adhesive layer wherein residual weight of the constituting material at 500° C is adjusted to be 5.5% or less, is stacked on a surface of a substrate film. Therefore, it is possible to decompose or sublimate (eliminate) substantially all of the constituent material of the adhesive layer (an adhesive agent composition) of the adhesive layer corresponding to a laser light irradiation part (streets between circuits in this example). As a result that substantially all of the constituent material of the adhesive layer corresponding to the irradiation part disappears, constituent material of the adhesive layer remained on other region (region contacting chips after cutting) than the irradiated part is not affected by laser light irradiation. As a result, arising of scattering chips, which are made into pieces, (scattering of chips) is prevented effectively and semiconductor chips can be produced with good workability.

The explanation was made on the case of using a semiconductor wafer as a workpiece, but the dicing assistance sheet of the present invention is not limited to this and may be also used for dicing a semiconductor package, optical device wafer using a sapphire substrate or copper substrate deposited with silver, etc., glass substrate, ceramic substrate, FPC or other organic material substrates and metal material of precision parts, etc.

### [EXAMPLES]

Below, an embodiment of the present invention will be explained further in detail by raising more specific examples. In the examples, "part" and "%" are based on weight unless otherwise mentioned.

In the examples, main adhesive agents 1 and 2, ultraviolet ray polymerizable compounds (compound A and compound B) 1 and 2, crosslinking agents 1 and 2 were as follows.

[Main Adhesive Agent 1] acrylic-type polymer (ORIBAIN BPS 5296, solid content 37%, TOYOCHEM Co., Ltd.)
[Main Adhesive Agent 2] acrylic-type polymer (Teisan Resin SG-600TEA, solid content 15%, Nagase ChemteX Corporation)

[Ultraviolet Polymerizable Compound 1] SHIKOH 7600B (solid content 80%, The Nippon Synthetic Chemical Industry Co., Ltd.)
[Ultraviolet Polymerizable Compound 2] Aronix (solid content 100%, TOAGOSEI Co., Ltd.)

[Crosslinking Agent 1] ORIBAIN BXX 4773 (TOYOCHEM Co., Ltd.)
[Crosslinking Agent 2] CORONATE L45E (isocyanate-type, Nippon Polyurethane Industry Co., Ltd.)

### [Examples 1-5]

### 1. Production of Laser Dicing Assistance Sheet

On one surface of a polyethylene film having a thickness of 100µm as a substrate, an adhesive layer application liquid having a composition below was applied by the bar-coating method, so that the thickness after drying becomes 25 µm, and dried to form adhesive layers 'a' to 'e', consequently, laser dicing assistance sheets for respective examples were produced.

### < Composition of Adhesive Layer Application Liquid >

* Main Adhesive Agent: kinds and blending amounts described in Table 1
* Ultraviolet Polymerizable Compound: kinds and blending amounts as shown in Table 1
* Crosslinking Agent: kinds and blending amounts as shown in Table 1
* Polymerization Initiator: blending amounts as shown in Table 1

### (Irgacure 184: BASF Ltd.)

**[Table 1]**

| Adhesive Layer | Application Liquid for Adhesive Layer (parts by weight) | | | | | | | |
|---|---|---|---|---|---|---|---|---|
| | Main Adhesive Agent: UV Polymerizable Compound (Solid Content Ratio) | Main Adhesive Agent (part) | | UV Polymerizable Compomund (part) | | Crosslinking Agent (part) | | Polymerization Initiator (part) |
| | | 1 | 2 | 1 | 2 | 1 | 2 | |
| a | 90 : 10 | 48.6 | - | 2.6 | - | 0.3 | - | 0.06 |
| b | 80 : 20 | 43.2 | - | - | 4.0 | 0.3 | - | 0.12 |
| c | 90 : 10 | - | 60.0 | 1.3 | - | - | 1.2 | 0.03 |
| d | 80 : 20 | - | 53.3 | 2.5 | - | - | 1.0 | 0.06 |
| e | 50 : 50 | - | 50.0 | - | 7.5 | - | 1.0 | 0.23 |

### 2. Measurement of Physical Properties of Adhesive Layer

Physical properties of respective adhesive layers were measured by following the procedure below by using a thermo gravimetry differential thermal analysis (TG/DTA 6200 type manufactured by SII Nano Technology Inc.) for the produced respective laser dicing assistance sheets (hereinafter, simply referred to as "assistance sheet"). The results are shown in Table 2.

First, after removing an adhesive layer of each of the produced assistance sheets, 3.5 ± 0.5mg was taken, pressed at a normal temperature and folded by using tweezers to form a shape not including bubbles to the maximum extent (measurement samples). Next, the measurement samples are placed in an aluminum cell, the temperature was raised from 30°C to 600 °C under condition of a temperature rising rate of 10 °C/min. in a nitrogen stream (50ml/min.), and weight reduction due to heating was measured.

### 2-1. Residual Weight (%) of Adhesive Layer at 500 °C

On a thermo gravimetry decrease curve with weight of measurement sample being 100% as the ordinate and a temperature as the abscissa, weight at 500 °C was obtained and the value was considered as residual weight (%) at 500 °C.

### 2-2. Residual Weight of Adhesive Layer at 250 °C (%)

From the thermo gravimetry decrease curve in 2-1 above, weight at 250 °C was obtained and the value was considered as residual weight (%) at 250 °C.

### 2-3. Weight Reduction Start Temperature (°C)

From the thermo gravimetry decrease curve in 2-1 above, a temperature at a crossing point of a tangent before start of weight reduction and a tangent of a part with the largest inclination was obtained and the value was considered the weight reduction start temperature.

### 2-4. 50% Weight Reduction Temperature (%) of Adhesive Layer

From the thermo gravimetry reduction curve in 2-1 above, a temperature at the point where the weight decreased by 50% was obtained and the value was considered 50% weight reduction temperature.

**[Table 2]**

| Adhesive Layer | Residual Weight (%) at 500°C | Residual Weight (%) at 250°C | Weight Reduction Start Temperature (°C) | 50% Weight Reduction Temperature (°C) |
|---|---|---|---|---|
| a | 4.4 | 98.9 | 347 | 396 |
| b | 3.0 | 99.5 | 345 | 407 |
| c | 5.2 | 99.0 | 374 | 407 |
| d | 6.0 | 99.6 | 374 | 420 |
| e | 7.9 | 98.5 | 373 | 438 |

### 3. Evaluation

The following characteristics were evaluated on each of the produced assistance sheets. The results are shown in Table 3.

### 3-1. Characteristic of Anti-Scattering of Chips

An adhesive layer surface of each of the produced assistance sheets was pressed against and bonded with a silicon wafer (8 inches) under the condition of rolling back and forth once on the wafer (step 1). Next, on a chuck table of a dicing apparatus having a sucking board made of quartz glass, the silicon wafer stuck to the assistance sheet was placed with the back surface (a surface with no adhesive layer stacked thereon) of the assistance sheet facing downward (step 2). Next, based on the laser irradiation condition below, a laser light was irradiated by using a Nd-YAG laser from the wafer side to perform cutting processing (full cut) on the wafer, so that a plurality of chips of 250×250 pieces (chip size (one piece) 0.2mm×0.2mm) were obtained from a region of 5cm×5cm (step 3). After that, a chip-holding rate (%) was obtained visually and a characteristic of anti-scattering of chips was evaluated based on the following criteria. The results are shown in Table 2.

⊚: Chip holding rate of 99.5% or more (extraordinarily excellent)
○: chip holding rate of 99% or more but less than 99.5% (excellent)
×: Chip holding rate of less than 90% (defective)

### < Laser Irradiation Condition >

wavelength: 355nm
repetition frequency: 100kHz
average output: 7w
irradiation times: 6 times/ 1 line
pulse width: 50ns
light conversion spot: oval shape (100µm in longitudinal axis and 10µm in short axis)
processing feed speed: 100mm/sec.

**[Table 3]**

| Example | Adhesive Layer | Anti Chip-Scattering | |
|---|---|---|---|
| | | Chip Holding Rate (%) | Evaluation |
| 1 | a | 100 | ⊚ |
| 2 | b | 99.9 | ⊚ |
| 3 | c | 99.4 | ○ |
| 4 | d | 70 | × |
| 5 | e | 0.05 | × |

### 4. Consideration

It was confirmed that, as shown in Table 1 and Table 2, those with residual weight of 5.5% or less at 500 °C (Examples 1-3 having adhesive layers 'a' to 'c') exhibited remarkably high chip-holding rates comparing with those with residual weight of 5.5% or more at 250 °C and exceeding 5.5% at 500 °C (Examples 4 and 5 having adhesive layers 'd' and 'e').

## Claims

1. A laser dicing assistance sheet having an adhesive layer, wherein residual weight (measured in a nitrogen stream (50ml/min.) with a temperature rising rate of 10 °C /min.) of a constituent material at 500 °C is adjusted to 5.5% or less.

2. The laser dicing assistance sheet according to claim 1, wherein the adhesive layer is adjusted so that residual weight (measured in a nitrogen stream (50ml/min.) with a temperature rising rate of 10 °C /min.) of the constituent material at 250 °C is 5.5% or more.

3. The laser dicing assistance sheet according to claim 2, wherein the adhesive layer is adjusted so that a weight reduction start temperature (measured in a nitrogen stream (50ml/min.) with a temperature rising rate of 10 °C /min.) is 150 °C or higher and lower than 500 °C.

4. The laser dicing assistance sheet according to any one of claims 1-3, wherein the adhesive layer is adjusted so that a 50% weight reduction temperature (measured in a nitrogen stream (50ml/min.) with a temperature rising rate of 10 °C /min.) is 300 °C or higher and lower than 500 °C.

5. The laser dicing assistance sheet according to any one of claims 1-4, wherein the adhesive layer is adjusted to have a thickness of 15µm or more and 35µm or less.
